# EUROPEAN PATENT APPLICATION

(11) **EP 2 056 348 A1**
(43) Date of publication of application: **06.05.2009**
(21) Application number: 08161554.4
(22) Date of filing: 31.07.2008
(51) Int. Cl.: H01L 25/065

(54) **Inverted Package-on-Package (POP) Assemblies and Packaging Methods for Integrated Circuits**

(30) Priority: 29.10.2007 US 978289
(71) Applicant: MediaTek Inc., 1st Science-Based Industrial Park Hsin-Chu 300 (TW)
(72) Inventor: Farley, James K., Kensington, NH 03833 (US)
(74) Representative: Peterreins, Frank

(57) **Abstract**

Integrated circuit package assemblies and packaging methods are provided. An integrated circuit package assembly includes a first circuit package including a first substrate having a top surface and a bottom surface, a first circuit die containing a programmable processor mounted to and electrically connected to the bottom surface of the first substrate, a bottom connector on the bottom surface of the first substrate and top circuit connections on the top surface of the first substrate, and a second circuit package mounted on the top surface of the first substrate and electrically connected to the top circuit connections of the first circuit package.

## Description

### Field of the Invention

This invention relates to integrated circuit packaging and, more particularly, to integrated circuit package assemblies and packaging methods which utilize an inverted package-on-package assembly.

### Background of the Invention

The trend in mobile phones and other mobile wireless devices is toward highly complex circuitry, increased functionality and miniaturization. For example, mobile wireless devices may include email, internet access, music downloads and cameras. As a result, packaging of the circuitry for such devices is challenging, with respect to overall dimensions and form factor.

A component of mobile wireless devices is a digital baseband processor and related memory, which function together to perform many operations of the wireless device. The packaging of these circuits is central to the packaging of the wireless device. A technique known as the POP (package-on-package) assembly technique has been utilized in existing wireless devices.

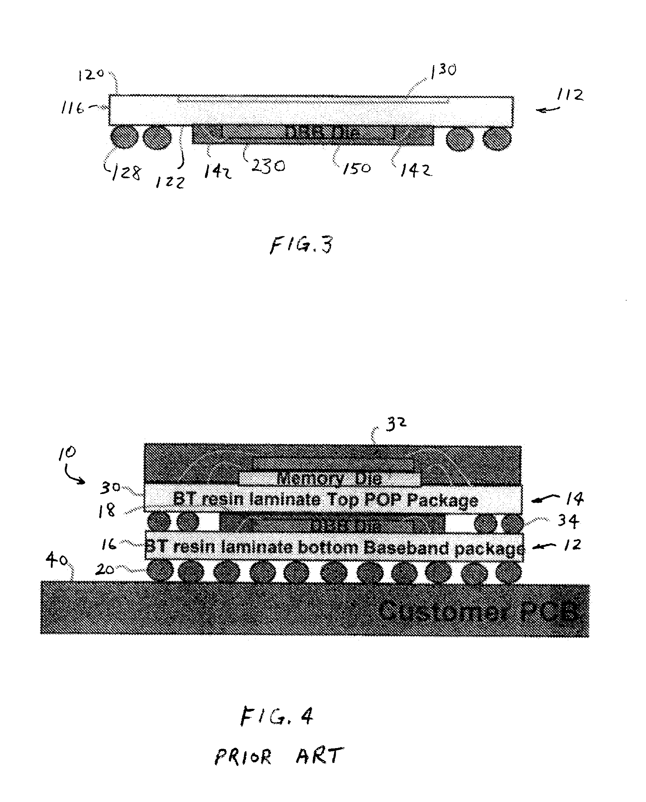

As shown in Fig. 4, a POP assembly 10 includes a bottom package 12 and a top package 14, which is mounted on bottom package 12. Bottom package 12 includes a laminate 16, a digital baseband die 18 mounted on a top surface of laminate 16 and a ball grid array 20 on a bottom surface of laminate 16. Top package 14 includes a laminate 30, a memory die 32 on a top surface of laminate 30 and a ball grid array 34 on a bottom surface of laminate 30. The ball grid array 34 provides connections to bottom package 16, and ball grid array 20 provides connections of the POP assembly 10 to a printed circuit board 40. The digital baseband die 18 and the memory die 32 are interconnected and function together as a unit. The POP assembly 10 is generally satisfactory but is relatively expensive and has limited flexibility.

Notwithstanding existing configurations, there is a need for improved integrated circuit packaging techniques which meet the requirements for miniature package size and low cost.

### Summary of the Invention

According to a first aspect of the invention, an integrated circuit package assembly is provided. The integrated circuit package assembly comprises a first circuit package including a first substrate having a top surface and a bottom surface, a first circuit die containing a programmable processor mounted to and electrically connected to the bottom surface of the first substrate, a bottom connector on the bottom surface of the first substrate and top circuit connections on the top surface of the first substrate, and a second circuit package mounted on the top surface of the first substrate and electrically connected to the top circuit connections of the first circuit package.

According to a second aspect of the invention, a method is provided for integrated circuit packaging. The method comprises providing a substrate having a top surface and a bottom surface, providing a bottom connector on the bottom surface of the substrate and top circuit connections on the top surface of the substrate, mounting a circuit die containing a programmable processor to the bottom surface of the substrate, and mounting a circuit package to the top surface of the substrate to form an integrated circuit package assembly.

According to a third aspect of the invention, a circuit package comprises a substrate having a top surface and a bottom surface, the substrate including top circuit connections on the top surface of the substrate for connection to another integrated circuit package, a circuit die containing a programmable processor mounted to and electrically connected to the bottom surface of the substrate; and a bottom connector on the bottom surface of the substrate.

### Brief Description of the Drawings

For a better understanding of the present invention, reference is made to the accompanying drawings, which are incorporated herein by reference and in which:
Fig. 1 is a schematic diagram of an integrated circuit package assembly in accordance with a first embodiment of the invention;
Fig. 2 is a schematic diagram of an integrated circuit package assembly in accordance with a second embodiment of the invention;
Fig. 3 is a schematic diagram of a bottom circuit package in accordance with a third embodiment of the invention; and
Fig. 4 is a schematic representation of a prior art integrated circuit package assembly.

### Detailed Description

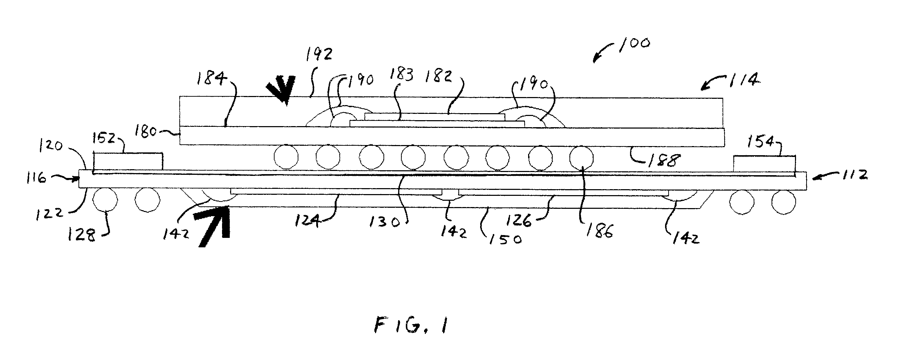

A schematic cross-sectional diagram of an integrated circuit package assembly in accordance with a first embodiment of the invention is shown in Fig. 1. An integrated circuit package assembly 100 includes a bottom circuit package 112 and a top circuit package 114, which is mounted on bottom circuit package 112. Bottom circuit package 112 includes a substrate 116 having a top surface 120 and a bottom surface 122, circuit die 124 and 126 mounted on bottom surface 122 of substrate 116, and a bottom connector 128 on bottom surface 122 of substrate 116.

The circuit die 124 and 126 include a programmable processor, such as a digital signal processor. More particularly, the programmable processor may be a digital baseband circuit for a mobile wireless device. In some embodiments, the bottom circuit package 112 includes a single circuit die mounted to bottom surface 122. In other embodiments, bottom circuit package 112 may include two or more circuit die mounted to bottom surface 122. For example, bottom circuit package 112 may include a programmable processor and a coprocessor configured to execute specified functions. Circuit die 124 and 126 are connected to each other and to substrate 116 using bonding wires 142. Circuit die 124 and 126 and bonding wires 142 are encapsulated, typically by a plastic encapsulant 150.

The substrate 116 of bottom circuit package 112 includes top circuit connections 130 for interconnection to top circuit package 114. Bottom connector 128 may comprise a ball grid array for interconnection to a printed circuit board (not shown in Fig. 1). Substrate 116 provides electrical connections to the printed circuit board via bottom connector 128 and electrical connections to top circuit package 114 via top circuit connections 130. Substrate 116 may be a laminate including electrical conductors for circuit interconnections. The top circuit connections 130, the connections to circuit die 124 and 126, and the connections to bottom connector 128 may be in the form of conductive pads.

By way of example only, substrate 116 may be a plastic based organic material such as BT resin (Bismaleimide-Triazine resin) or high strength BT resin, may be ceramic based or may be polyimide based. The thickness of substrate 116 is typically in a range of 0.2 mm to 0.5 mm but is not limited to this range. In one specific example, substrate 116 may be a BT resin laminate having a thickness of 0.3 mm. It will be understood that the above materials and dimensions are given by way of example only and are not limiting as to the scope of the present invention.

Bottom circuit package 112 may optionally include one or more additional circuit components 152 and 154 on top surface 120 of substrate 116. The circuit components 152 and 154 may be circuit die, such as RF die, passive components, or any other circuit components. The circuit components 152 and 154 may be connected to the other circuitry via top circuit connections 130 on substrate 116.

Top circuit package 114 includes a substrate 180, circuit die 182 and 183 on a top surface 184 of substrate 180, and a bottom connector 186 on a bottom surface 188 of substrate 180. Substrate 180 of top circuit package 114 may be a laminate including electrical conductors for circuit interconnections. Bottom connector 186 may be a ball grid array for mounting and interconnection to bottom circuit package 112. Circuit die 182 and 183 may be memory devices that, in operation, provide program instructions and data to the programmable processor of bottom package 112. Circuit die 182 and 183 are interconnected to substrate 180 via bonding wires 190 and are encapsulated by an encapsulant 192. Top circuit package 114 may include one or more memory devices or other circuits within the scope of the invention. In some embodiments, different types of memory devices may be included in top circuit package 114. In some embodiments, top circuit package 114 is a standard memory package or a modification of a standard memory package.

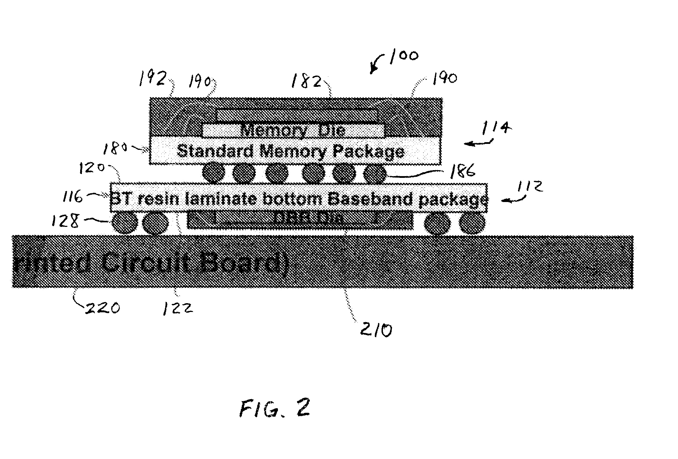

A cross-sectional schematic diagram of an integrated circuit package assembly in accordance with a second embodiment of the invention is shown in Fig. 2. Like elements in Figs. 1 and 2 have the same reference numerals. The embodiment of Fig. 2 differs from the embodiment of Fig. 1 in that bottom circuit package 112 includes a single circuit die 210 mounted to the bottom surface 122 of substrate 116. Circuit die 210 includes a programmable processor, such as a digital signal processor. Integrated circuit package assembly 100 is mounted to and electrically connected to a printed circuit board 220 via bottom connector 128 on bottom circuit package 112. External connections to and from integrated circuit package assembly 100 are provided through bottom connector 128. As noted above, bottom connector 128 may be a ball grid array.

A schematic cross-sectional diagram of a bottom circuit package in accordance with a third embodiment of the invention is shown in Fig. 3. Like elements in Figs. 1 and 3 have the same reference numerals. The embodiment of Fig. 3 does not include additional components on the top surface 120 of substrate 116. The embodiment of Fig. 3 includes a single circuit die 230 mounted to and electrically connected to bottom surface 122 of substrate 116. Circuit die 230 includes a programmable processor, such as a digital signal processor. It may be observed that the top surface 120 of substrate 116 is available for mounting and electrical connection of a top circuit package containing desired circuitry. In some embodiments, two or more bottom circuit packages may be stacked to provide increased packaging density.

Having thus described several aspects of at least one embodiment of this invention, it is to be appreciated various alterations, modifications, and improvements will readily occur to those skilled in the art. Such alterations, modifications, and improvements are intended to be part of this disclosure, and are intended to be within the spirit and scope of the invention. Accordingly, the foregoing description and drawings are by way of example only.

What is claimed is:

### EMBODIMENTS

Although the invention is defined in the enclosed claims, it is to be understood that the present invention can alternatively be defined in accordance with the following embodiments:
1. An integrated circuit package assembly comprising a first circuit package including a first substrate having a top surface and a bottom surface, a first circuit die containing a programmable processor mounted to and electrically connected to the bottom surface of the first substrate, a bottom connector on the bottom surface of the first substrate and top circuit connections on the top surface of the first substrate; and a second circuit package mounted on the top surface of the first substrate and electrically connected to the top circuit connections of the first circuit package.
2. An integrated circuit package assembly as defined in embodiment 1, wherein the programmable processor comprises a digital signal processor.
3. An integrated circuit package assembly as defined in embodiment 1, wherein the programmable processor comprises a digital baseband circuit for a mobile wireless device.
4. An integrated circuit package assembly as defined in embodiment 1, wherein the bottom connector is configured for coupling the integrated circuit package assembly to a printed circuit board.
5. An integrated circuit package assembly as defined in embodiment 1, wherein the bottom connector comprises a ball grid array.
6. An integrated circuit package assembly as defined in embodiment 4, wherein the bottom connector is disposed around the first circuit die.
7. An integrated circuit package assembly as defined in embodiment 1, wherein the second circuit package includes a memory device.
8. An integrated circuit package assembly as defined in embodiment 1, wherein the second circuit package is larger in area than the first circuit package.
9. An integrated circuit package assembly as defined in embodiment 1, wherein the second circuit package includes a second substrate having a second circuit die affixed thereto.
10. An integrated circuit package assembly as defined in embodiment 9, wherein the first and second substrates are laminates.
11. An integrated circuit package assembly as defined in embodiment 1, further comprising one or more circuit components mounted on the top surface of the first substrate and electrically connected to the top circuit connections of the first circuit package.
12. A method for integrated circuit packaging comprising providing a substrate having a top surface and a bottom surface; providing a bottom connector on the bottom surface of the substrate and top circuit connections on the top surface of the substrate; mounting a circuit die containing a programmable processor to the bottom surface of the substrate; and mounting a circuit package to the top surface of the substrate to form an integrated circuit package assembly.
13. A method as defined in embodiment 12, wherein the bottom connector is configured for coupling the integrated circuit package assembly to a printed circuit board.
14. A method as defined in embodiment 12, further comprising mounting one or more circuit components on the top surface of the substrate and electrically connecting the circuit components to the top circuit connections.
15. A method as defined in embodiment 12, wherein the circuit package contains a memory device.
16. A circuit package comprising a substrate having a top surface and a bottom surface, the substrate including top circuit connections on the top surface of the substrate for connection to another integrated circuit package; a circuit die containing a programmable processor mounted to and electrically connected to the bottom surface of the substrate; and a bottom connector on the bottom surface of the substrate.
17. A circuit package as defined in embodiment 16, wherein the bottom connector comprises a connector configured for coupling the integrated circuit package to a printed circuit board.
18. A circuit package as defined in embodiment 17, wherein the bottom connector comprises a ball grid array.
19. A circuit package as defined in embodiment 16, further comprising one or more circuit components mounted to and electrically connected to the top surface of the substrate.

## Claims

1. An integrated circuit package assembly comprising:
a first circuit package including a first substrate having a top surface and a bottom surface, a first circuit die containing a programmable processor mounted to and electrically connected to the bottom surface of the first substrate, a bottom connector on the bottom surface of the first substrate and top circuit connections on the top surface of the first substrate; and
a second circuit package mounted on the top surface of the first substrate and electrically connected to the top circuit connections of the first circuit package.

2. An integrated circuit package assembly as defined in claim 1, wherein the programmable processor comprises a digital baseband circuit for a mobile wireless device.

3. An integrated circuit package assembly as defined in claim 1, wherein the bottom connector is configured for coupling the integrated circuit package assembly to a printed circuit board.

4. An integrated circuit package assembly as defined in claim 1, wherein the bottom connector comprises a ball grid array.

5. An integrated circuit package assembly as defined in claim 4, wherein the bottom connector is disposed around the first circuit die.

6. An integrated circuit package assembly as defined in claim 1, wherein the second circuit package is larger in area than the first circuit package.

7. An integrated circuit package assembly as defined in claim 1, wherein the second circuit package includes a second substrate having a second circuit die affixed thereto.

8. An integrated circuit package assembly as defined in claim 1, further comprising one or more circuit components mounted on the top surface of the first substrate and electrically connected to the top circuit connections of the first circuit package.

9. A method for integrated circuit packaging comprising:
providing a substrate having a top surface and a bottom surface;
providing a bottom connector on the bottom surface of the substrate and top circuit connections on the top surface of the substrate;
mounting a circuit die containing a programmable processor to the bottom surface of the substrate; and
mounting a circuit package to the top surface of the substrate to form an integrated circuit package assembly.

10. A method as defined in claim 9, wherein the bottom connector is configured for coupling the integrated circuit package assembly to a printed circuit board.

11. A method as defined in claim 9, further comprising mounting one or more circuit components on the top surface of the substrate and electrically connecting the circuit components to the top circuit connections.

12. A circuit package comprising:
a substrate having a top surface and a bottom surface, the substrate including top circuit connections on the top surface of the substrate for connection to another integrated circuit package;
a circuit die containing a programmable processor mounted to and electrically connected to the bottom surface of the substrate; and
a bottom connector on the bottom surface of the substrate.

13. A circuit package as defined in claim 12, wherein the bottom connector comprises a connector configured for coupling the integrated circuit package to a printed circuit board.

14. A circuit package as defined in claim 13, wherein the bottom connector comprises a ball grid array.

15. A circuit package as defined in claim 12, further comprising one or more circuit components mounted to and electrically connected to the top surface of the substrate.
